(19) Europäisches Patentamt
European Patent Office
Office européen des brevets

(11) **EP 1 792 347 B1**

(12) **EUROPÄISCHE PATENTSCHRIFT**

(45) Veröffentlichungstag und Bekanntmachung des Hinweises auf die Patenterteilung:
**28.12.2016 Patentblatt 2016/52**

(21) Anmeldenummer: **05766765.1**

(22) Anmeldetag: **15.07.2005**

(51) Int Cl.:
*H01L 29/868* (2006.01)　　*H01L 27/07* (2006.01)
*H01L 27/06* (2006.01)　　*H01L 27/08* (2006.01)

(86) Internationale Anmeldenummer:
**PCT/EP2005/053402**

(87) Internationale Veröffentlichungsnummer:
**WO 2006/029921 (23.03.2006 Gazette 2006/12)**

(54) **HALBLEITERANORDNUNG ZUR SPANNUNGSBEGRENZUNG**

SEMICONDUCTOR ASSEMBLY FOR LIMITING VOLTAGE

DISPOSITIF A SEMI-CONDUCTEUR POUR LIMITER LA TENSION

(84) Benannte Vertragsstaaten:
**DE ES FR GB IT SE**

(30) Priorität: **13.09.2004 DE 102004044141**

(43) Veröffentlichungstag der Anmeldung:
**06.06.2007 Patentblatt 2007/23**

(73) Patentinhaber: **ROBERT BOSCH GMBH
70442 Stuttgart (DE)**

(72) Erfinder: **GOERLACH, Alfred
72127 Kusterdingen (DE)**

(56) Entgegenhaltungen:
EP-A- 0 485 059　　EP-A- 1 191 594
DE-A1- 2 506 102　　DE-A1- 3 008 034
DE-A1- 3 631 136　　US-A- 5 142 347

EP 1 792 347 B1

**Beschreibung**

Die Erfindung betrifft eine Halbleiteranordnung zur Spannungsbegrenzung.

Stand der Technik

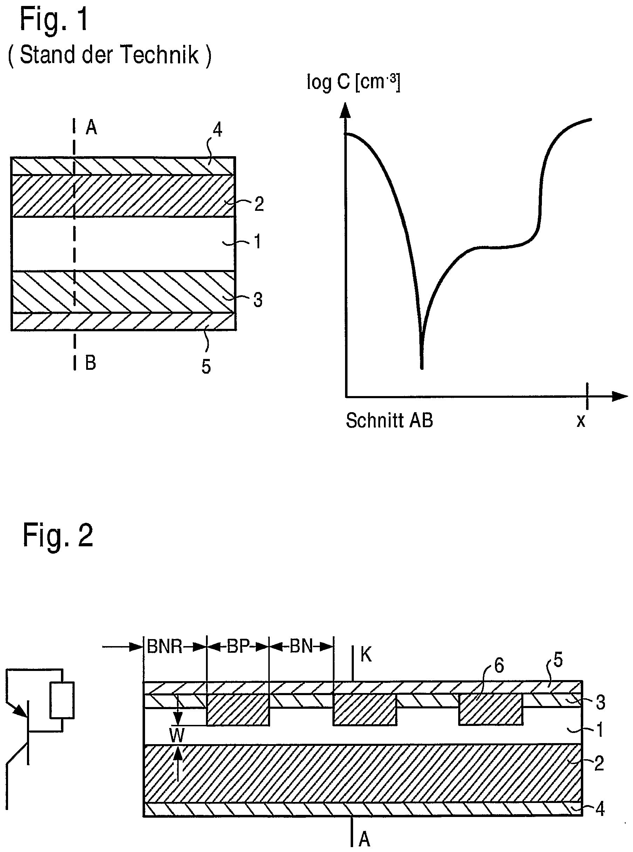

Es ist bereits bekannt, Halbleiterdioden zur Spannungsbegrenzung einzusetzen. Eine derartige bekannte Halbleiterdiode ist in der Figur 1 dargestellt. Bei dieser Halbleiterdiode handelt es sich um eine pn-Diode, bei welcher eine p-dotierte Schicht 2 in ein homogen n-dotiertes Gebiet 1 eindiffundiert ist. Zur Reduktion des Bahnwiderstandes und einer besseren ohmschen Anbindung des n-Halbleiters an die Metallisierung wird das n-dotierte Gebiet 1 von der Waferrückseite her im Sinne einer $n^+$-Dotierung stark n-dotiert (Gebiet 3). Mit den Bezugszahlen 4 und 5 sind Metallschichten bezeichnet. Wird an eine solche Diode eine Sperrspannung US angelegt, dann steigt der Strom stark an, sobald die Durchbruchspannung UZ überschritten wird. Die Ursache des Stromanstiegs und damit der Spannungsbegrenzung liegt in dem einsetzenden Avalanche- bzw. Lawineneffekt begründet. Beim Anlegen einer Sperrspannung bildet sich an der pn-Grenzfläche eine sogenannte Raumladungszone aus. Ab einer bestimmten elektrischen Feldstärke $E_{krit}$ von ca. $2 \cdot 10^5$ bis $4 \cdot 10^5$ V/cm werden Ladungsträger in der Raumladungszone so stark beschleunigt, dass sie bei Stößen mit dem Kristallgitter Bindungen des Halbleiters aufbrechen und dadurch weitere Elektronen und Löcher erzeugen, die ihrerseits beschleunigt werden und weitere Bindungen aufbrechen. Dadurch steigt der Strom steil an.

Ein Nachteil derartiger Dioden besteht darin, dass die Durchbruchspannung mit zunehmender Temperatur ansteigt. Sie besitzt einen positiven Temperaturkoeffizienten TK. Wird eine solche Diode kurzzeitig bei hohen Strömen im Durchbruch betrieben, dann kann die als Wärme anfallende Leistung, das Produkt aus dem Durchbruchstrom IZ und der Durchbruchspannung UZ, sehr hoch werden. Bei Dioden, die in Kraftfahrzeuggeneratoren zur Gleichrichtung verwendet werden, treten im sogenannten Load-Dump-Betrieb Leistungen auf, die im Bereich mehrerer Kilowatt liegen. Als Folge davon erwärmt sich die Diode und die Durchbruchspannung UZ steigt stark an. Dies ist für viele Anwendungen nachteilig. Beispielsweise beträgt die maximal zugelassene Spannung in künftige 42V-Bordnetzen nur 58 V. Da die Generatorspannung in solchen Systemen bis auf 48 V ansteigen kann, muss der Temperaturkoeffizient der Durchbruchspannung vernachlässigbar klein sein. Zu beachten ist dabei, dass neben dem Einfluss der Temperatur auf die Durchbruchspannung auch der Bahnwiderstand sowie Fertigungstoleranzen zu berücksichtigen sind.

Vorteile der Erfindung

Demgegenüber weist eine Halbleiteranordnung mit den im Patentanspruch 1 angegebenen Merkmalen den Vorteil auf, dass ihre Durchbruchspannung nahezu unabhängig von der Temperatur ist. Dies wird dadurch erreicht, dass eine Halbleiteranordnung vorgeschlagen wird, die im wesentlichen einer Kombination einer pn-Diode mit einer Punchthrough-Diode entspricht, wobei letztere nachfolgend auch als PT-Diode bezeichnet wird. Eine PT-Diode weist eine npn- bzw. pnp-Struktur auf und zeigt bei entsprechender Dimensionierung eine nur geringe Temperaturabhängigkeit seiner Begrenzungsspannung UZPT. Diese Begrenzungsspannung der PT-Diode wird derart gewählt, dass sie stets kleiner ist als die Durchbruchspannung UZPN der pn-Diode. Die Durchbruchspannung der gesamten Halbleiteranordnung ist dann die Begrenzungsspannung der PT-Diode.

Aus den Entgegenhaltungen DE 36 31136 A1, US-A-5 142 347, EP-A-0 485 059, DE 25 06 102 A1, EP-A-1 191 594) sind Halbleiteranordnungen zur Gleichrichtung von Spannungen oder Strömen bekannt die verschiedene Diodenanordnungen umfassen. Diese Diodenanordnungen sind üblicherweise aus PN-Übergängen mit verschiedenartigen Dotierstoffkonzentrationen aufgebaut. Durch ihren besonderen Aufbau ist gewährleistet, dass sie in Durchlassrichtung einen geringen Widerstand und in Sperrrichtung einen hohen Widerstand aufweisen, wobei bei Überschreiten einer maximal möglichen Sperrspannung starke Stromanstiege auftreten, die zu unerwünschter Erwärmung führen können. Zumindest einige der genannten bekannten Halbleiteranordnungen weisen zusätzlich Mittel zur Spannungsbegrenzung auf, die jedoch temperaturabhängig sind.

Weitere vorteilhafte Eigenschaften der Erfindung ergeben sich aus deren nachfolgender beispielhafter Erläuterung anhand der Zeichnungen.

Zeichnung

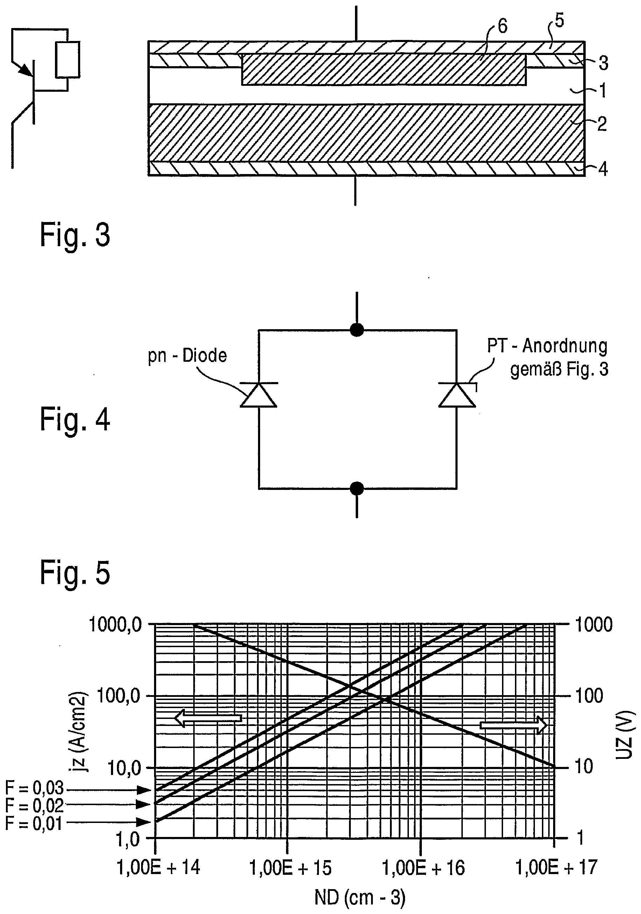

Die Figur 1 zeigt eine schematische Darstellung des Querschnitts und des Dotierprofils einer pn-Diode, wie sie bisher zur Spannungsbegrenzung eingesetzt wurde. Die Figur 2 zeigt eine schematische Darstellung sowie ein Ersatzschaltbild einer Halbleiteranordnung gemäß einer ersten Ausführungsform der Erfindung. Die Figur 3 zeigt eine schematische Darstellung sowie ein Ersatzschaltbild einer Halbleiteranordnung gemäß einer weiteren Ausführungsform der Erfindung. Die Figur 4 zeigt ein Schaltbild einer weiteren Ausführungsform der Erfindung, bei welcher eine herkömmliche pn-Diode und die in der Figur 3 gezeigte Anordnung parallel geschaltet sind. Die Figur 5 zeigt ein Diagramm, in welchem die maximal erzielbare Durchbruchstromdichte jz und die maximale Durchbruchspannung UZ in Abhängigkeit von der Dotierkonzentration des Gebietes 1 für drei unterschiedliche Stromfehlerfaktoren F veranschaulicht sind.

Beschreibung

Die Figur 2 zeigt eine schematische Darstellung sowie ein Ersatzschaltbild einer Halbleiteranordnung gemäß einer ersten Ausführungsform der Erfindung.

Bei dieser Ausführungsform ist über einer hoch p-dotierten Halbleiterschicht 2 eine schwach n-dotierte Halbleiterschicht 1 ganzflächig angebracht. In diese schwach n-dotierte Halbleiterschicht 1 sind abwechselnd p-dotierte Halbleiterschichten 6 und hoch n-dotierte Halbleiterschichten 3 von der Oberfläche aus so eingebracht, dass sich zumindest die p-dotierten Halbleiterschichten 6 und 2 nicht berühren. Vorzugsweise befindet sich die n-dotierte Halbleiterschicht 3 am äußeren Rand der in Form eines Chips realisierten Halbleiteranordnung und umschließt diesen Rand vollständig. Die Oberseite und die Unterseite der dargestellten Halbleiteranordnung sind mit dünnen Metallschichten 5 und 4 versehen. Diese unstrukturierten Metallisierungen stellen den ohmschen Kontakt zur Halbleiteranordnung her. Dabei wird der Metallkontakt 4 als Anode und der Metallkontakt 5 als Kathode bezeichnet.

Beim Anlegen einer Spannung zwischen Anode 4 und Kathode 5 in der Weise, dass der Pluspol mit der Anode und der Minuspol mit der Kathode verbunden ist, d.h. bei einer Durchlasspolung der Anordnung, fließt nach dem Überwinden der Diffusionsspannung UD ein Strom über die Metall- und Halbleiterbereiche $4 \to 2 \to 1 \to 3 \to 5$.

Bei einer Vertauschung der Spannung bzw. einer Umpolung ist der Stromfluss - abgesehen von einem geringen Sperrstrom - unterbrochen. Wird diese Spannung erhöht, dann dehnt sich die Raumladungszone am pn-Übergang 2/1 weiter inadas n-Gebiet 1 hinein aus. Bei der vorliegenden Erfindung erreicht der Rand der Raumladungszone den p-dotierten Halbleiterbereich 6 bei einer Spannung, die kleiner ist als die Avalanchedurchbruchspannung UZPN des pn-Überganges 2/1. Stößt die Raumladungszone bei der Spannung UZPT am der Schicht 6 an, dann beginnt Strom über die Schichten $4 \to 2 \to 1 \to 6 \to 5$ zu fließen. Die Bedingung für einen Durchbruch ist erreicht. Diese Spannung UZPT ist nahezu unabhängig von der Temperatur.

Für die Stromabhängigkeit der Spannung UZPT gilt unter Vernachlässigung der Bahnwiderstände folgende Beziehung:

$$\text{UZPT} = \frac{q \bullet \text{ND} \bullet \text{W}^2}{2 \bullet \varepsilon s \bullet \varepsilon 0} + \frac{\text{W}^2}{2 \bullet \varepsilon s \bullet \varepsilon 0 \bullet vs} \bullet jz \qquad (1)$$

Dabei gilt:

Elemantarladung q=1, $6 \cdot 10^{-19}$ As;
relative Dielektrizitätskonstante für Silizium es = 11,9;
absolute Dielektrizitätskonstante $\varepsilon 0$ = 8,854$\cdot 10^{-14}$ F/cm;
Sättigungsgeschwindigkeit der Ladungsträger vs $\approx 10^7$cm/s;
ND = Dotierungskonzentration der Schicht 1;
W = Abstand zwischen den Gebieten 6 und 2 (dies entspricht der maximalen Raumladungsweite im schwach n-dotierten Gebiet 1); und
jz= Durchbruchstromdichte.

Diese vorgenannten Parameter sind im interessierenden Temperaturbereich, der bei ca. -50°C - 220°C liegt, nicht oder nur in geringem Umfang temperaturabhängig.

Die Dotierkonzentration ND der Schicht 1 und die Weite W der Schicht 1 wird so eingestellt, dass die Punchthrough-Begrenzungsspannung UZPT kleiner ist als die Avalanchedurchbruchspannung UZPN des pn-Überganges 21:

$$\text{UZPT} < \text{UZPN} \qquad (2)$$

Weiter muss gewährleistet sein, dass die Durchbruchspannung UCEO des parasitären pnp-Transistors, bestehend aus den Schichten 6(Emitter), 1 (Basis) und 2 (Kollektor) die Punchthrough-Begrenzungsspannung UZPT nicht unterschreitet.

$$UZPT < UCEO \qquad (3)$$

Mit einem Fitparameter n, der etwa zwischen 4 und 7 liegt, lässt sich die Durchbruchspannung UCEO des parasitären pnp-Transistors als Funktion der Stromverstärkung B in Emitterschaltung ausdrücken als:

$$UCEO = \frac{UZPN}{\sqrt[n]{B + 1}} \qquad (4)$$

Dies erfordert, dass die Stromverstärkung B des pnp-Transistors sehr klein gewählt werden muss. Für die vorzugsweise betrachteten geringen Weiten W ist die Stromverstärkung B praktisch nur vom Emitterwirkungsgrad $\gamma_p$ abhängig, da der sogenannte Basistransportfaktor $\alpha$ den Wert 1 annimmt. Für die Stromverstärkung B ergibt sich dann:

$$B = \frac{\gamma_p}{1 - \gamma_{p\gamma}} \qquad (5)$$

Für den Fall, dass bei einem pnp-Transistor die Weiten von Basis W und Emitter WAE wesentlich kleiner als die entsprechenden Diffusionslängen Lp und Ln der Minoritätsträger sind, lässt sich der Emitterwirkungsgrad näherungsweise ausdrücken als:

$$\gamma_p = 1/[1+3(\int_W NDdx / \int_{WAE} NAEdx)] \qquad (6)$$

NAE stellt dabei die Konzentration der Akzeptoren des E-mitters dar. Der Emitterwirkungsgrad $\gamma_p$ und damit auch die Stromverstärkung B wird klein, wenn die Konzentration NAE gering oder die Weite der Emitterschicht WAE sehr klein ist. Die Reduktion von $\gamma_p$ bei kleinem WAE gilt nur für den Fall, dass WAE < Ln ist. Die Ermitterkonzentration an der Halbleiteroberfläche kann nicht beliebig klein gewählt werden, da sonst die Metall-Halbleiterverbindung 5, 6 kein ohmsches Verhalten mehr aufweist. Deshalb muss in der erfindungsgemäßen Anordnung eine sehr dünne Emitterschicht, z. B. WAE < 0,1 Mikrometer, gewählt werden, um niedrige Emitterwirkungsgrade $\gamma_p$ und damit hohe Spannungen UCEO zu erhalten.

Die im zweiten Term von Gleichung (1) beschriebene Stromabhängigkeit von UZPT kann durch geeignete Dimensionierung der erfindungsgemäßen Anordnung minimiert werden. Der Faktor F beschreibt den maximalen zulässigen Stromfehler.

$$F = \frac{USC}{UPT + USC} \qquad (7)$$

Dabei stellt UPT den ersten Term und USC den zweiten Term der Gleichung (1) dar. Aus Gleichung (7) ergibt sich, dass die maximal erzielbare Durchbruchstromdichte jz bei gewähltem Faktor F von der Dotierkonzentration ND des Gebietes 1 abhängt. Die maximal mögliche Durchbruchstromdichte jz steigt dabei mit zunehmender Dotierkonzentration ND des Gebietes 1 und zunehmendem Stromfehler F an. Dies ist in Figur 5 für drei unterschiedliche Stromfehlerfaktoren F dargestellt. Zusätzlich ist in Fig. 5 die maximal erreichbare Durchbruchspannung UZ für einen gewissen Bereich der Dotierkonzentration ND dargestellt. Dabei wurde die Näherung für die Durchbruchspannung eines abrupten pn-Überganges verwendet, die tendenziell zu niedrige Werte ergibt. Außerdem wurde angenommen, dass UCEO nicht kleiner als UZPN ist.

Bei der bekannten Ausführung nach Fig. 1 endet der pn-Übergang im Bereich des Sägegrabens des Chips. Das Kristallgitter in diesem Bereich ist, je nach Sägeart und - prozess, bis zu einer Tiefe von einigen bis einigen zehn Mikrometer gestört. Dieser Bereich des gestörten Kristallgitters wird als Damagezone bezeichnet. Solche Bereiche weisen hohe Zustandsdichten in der Bandlücke auf. Dadurch erhöht sich die Rekombinationswahrscheinlichkeit für Ladungsträger und damit der Sperrstrom. Außerdem ist die zur Auslösung des Lawineneffektes benötigte elektrische Feldstärke $E_{krit}$ im Bereich der Damagezone im allgemeinen kleiner als im inneren, ungestörten Chipbereich. Deswegen findet der Lawinendurchbruch zuerst am Chiprand statt. Die Folge davon sind Vordurchbrüche, die sich in verrundeten Sperrkennlinien äußern. In Folge der erhöhten Sperrströme und der Vordurchbrüche in den Randbereichen sind diese Bereiche thermisch und elektrisch stärker belastet als der Bereich im Inneren des Chips. Dies hat eine deutlich reduzierte Impulsfestigkeit der Diode zur Folge. Bei derartigen Dioden ist es deshalb üblich, den gestörten Chipbereich, z. B. durch Ätzen in KOH, abzutragen.

Bei der erfindungsgemäßen Anordnung nach Fig. 2 und auch Fig. 3 endet der pn-Übergang ebenfalls im Bereich des gestörten Sägegrabens. Da im Gegensatz zu einer herkömmlichen Anordnung die Spannungsbegrenzung nicht mehr am pn-Übergang, sondern an der innenliegenden Punchthrough-Struktur erfolgt, tritt keine reduzierte Impulsfestigkeit auf, solange die Bedingungen (2) uhd (3) auch für den Rand gelten. Gemäß einer bevorzugten Auslegung der neuen Anordnung ist die Breite BNR des Gebietes 3 im Bereich des umlaufenden äußeren Chiprand größer als der Bereich der Damagezone. Dabei kann die Breite BNR insbesondere auch größer gewählt werden als die Breite BN der innenliegenden hoch n-dotierten Gebiete 3.

Die innenliegenden hoch n- oder p-dotierten Gebiete 3 bzw. 6 können in verschiedenen geometrischen Anordnungen, beispielsweise als Streifen, Kreise oder Sechsecke, ausgeführt sein. Die Flächen der Gebiete 3 und 6 können in Abhängigkeit von der jeweiligen Anwendung in weiten Bereichen variiert werden. Im Fall einer Streifengeometrie kann die Weite BN des Bereiches 3 größer, kleiner oder gleich der Weite BP des Bereiches 6 sein.

Außerdem können die Breiten BN und BP stark variieren. Die minimalen Breiten BN und BP entsprechen etwa den jeweiligen vertikalen Eindringtiefen der Schichten in das Gebiet 1. Wenn die maximalen Breiten erreicht sind, liegt jeweils nur ein zusammenhängendes Gebiet 3 und 6 vor. Die maximale Breite BN ist die Differenz zwischen der Länge der Chipkante und der minimalen Breite BP. Der andere, wichtigere Grenzfall ist in der Fig. 3 gezeigt. Im Inneren der Anordnung ist der Bereich 3 vollständig entfernt. Für die Breite BP gilt dann: Länge der Chipkarte minus zwei mal Breite BNR. Diese Anordnung ist für den Betrieb in Flussrichtung weniger geeignet, da sie nahezu keine Bereich des pn-Diodenanteils mehr enthält. Sie kann aber in vorteilhafter Weise als Punchthrough-Diode eingesetzt werden. In weiteren Ausführungen muss die Weite der Gebiete 3 und 6 BN bzw. BP innerhalb des Chips nicht konstant sein, sondern kann je nach Lage variieren. So kann BP in der Nähe des Chiprandes sehr klein sein, in Richtung Chipmitte zunehmen, usw.. Die Anzahl der p-dotierten Gebiete 3 und n-dotierten Gebiete 6 hängt von der oben beschriebenen Wahl der Geometrien und den Abmessungen von BNR, BN und BP ab. Die Eindringtiefe der p-dotierten Schicht 6 kann - wie in Fig. 2 schematisch gezeigt - größer als die Eindringtiefe der n-dotierten Schicht 3, aber auch etwas kleiner oder gleich sein.

Ein möglicher, einfacher Herstellungsprozess der Ausführungsform nach Fig. 2 wird für eine Anordnung mit einer Durchbruchspannung UZ von ca. 46 Volt, wie sie für den Einsatz in 42V Kfz-Bordnetzen besonders vorteilhaft ist, gezeigt.

Selbstverständlich kann eine solche Diode auch für größere oder kleinere Spannungen ausgelegt werden. Dabei ist nur darauf zu achten, dass die Weite der Raumladungszone, der Abstand W, nicht zu groß wird. Andernfalls wirkt sich der zweite Term in der Gleichung (1) bei hohen Stromdichten nachteilig aus. Mit Hilfe von Fig. 5 kann die maximal erreichbare Durchbruchspannung UZ in Abhängigkeit von der Dotierkonzentration abgeschätzt werden.

Auf ein hoch p-dotiertes Siliziumsubstrat wird beispielsweise eine n-dotierte Schicht mit einer effektiven Dicke von 2,65 - 2,75 Mikrometer und einer Phosphor-Dotierstoffkonzentration ND = $8*10^{15}$ cm$^{-3}$ in einem Epitaxieprozess abgeschieden. Die Gebiete 3 und 6 werden in herkömmlicher Weise mittels Phototechnik und Ionenimplantation eingebracht und beispielsweise mittels rapid thermal processing (RPT) ausgeheilt. Dabei wird zur Erzeugung der flachen p-dotierten Gebiete 6 Bor mit einer Dosis von $2*10^{13}$ cm$^{-2}$ bei einer Energie von 10keV durch ein 30nm dickes Streuoxid implantiert. Anschließend werden Vorderseite und Rückseite in bekannter Art und Weise mit einem geeigneten Metallsystem versehen. Vor dem Metallisierungsprozess kann die p-dotierte Schicht 2 teilweise abgeschliffen werden, um die Waferdicke, und damit den Bahnwiderstand, zu reduzieren. Gegebenenfalls kann insbesonders eine lötfähige Metallisierung wie beispielsweise Cr/NiV/Ag, verwendet werden. Dadurch ist es möglich, die Bauteile auf der Vorder- und Rückseite in ein geeignetes Gehäuse einzulöten, beispielsweise in ein sogenanntes Einpressgehäuse, wie es üblicherweise bei Dioden für Kfz-Gleichrichter Verwendung findet.

Nach dem Vereinzeln und Einlöten der Chips in ein Einpressgehäuse kann bei Bedarf die Damagezone am Chiprand durch geeignetes nasschemisches Ätzen oder Gasphasenätzen entfernt werden, um die durch die Damagezone verursachten Sperrströme zu reduzieren.

Alternativ ist es natürlich auch möglich, eine Anordnung gemäß Fig. 2 oder Fig. 3 herzustellen, bei der alle Dotierungstypen vertauscht sind, d.h. n-dotierte Gebiete werden durch p-dotierte Gebiete ersetzt und umgekehrt.

In der Fig. 4 ist ein weiteres Ausführungsbeispiel gezeigt. Dabei wird eine herkömmliche Anordnung, beispielsweise gemäß der Fig. 1, einer erfindungsgemäßen Anordnung nach Fig. 3 parallelgeschaltet.

## Patentansprüche

1. Halbleiteranordnung zur Spannungsbegrenzung, mit einer ersten Deckelektrode (4), einer mit der ersten Deckelektrode (4) verbundenen, stark p-dotierten Halbleiterschicht (2), einer mit der stark p-dotierten Halbleiterschicht (2) verbundenen, schwach n-dotierten Halbleiterschicht (1), und einer zweiten Deckelektrode (5), wobei zwischen der schwach n-dotierten Halbleiterschicht (1) und der zweiten Deckelektrode (5) nebeneinander im Wechsel mindestens eine p-dotierte Halbleiterschicht (6) und zwei hoch n-dotierte Halbleiterschichten (3) vorgesehen sind, wobei die Durchbruchspannung nahezu unabhängig von der Temperatur ist und

die Halbleiteranordnung einer Kombination einer pn-Diode mit einer Punch through-Diode entspricht und wobei die Begrenzungsspannung (UZPT) der Punch through-Diode so gewählt wird, dass sie stets kleiner ist als die Durchbruchspannung (UZPN) der pn-Diode,

wobei

ein parasitäre pnp-Transistor durch die zwischen der schwach n-dotierten Halbleiterschicht (1) und der zweiten Deckelektrode (5) angeordnete mindestens eine p-dotierte Halbleiterschicht (6) als Emitter, der schwach n-dotierten Halbleiterschicht (1) als Basis und der mit der ersten Deckelektrode (4) verbundenen, stark p-dotierten Halbleiterschicht (2) als Kollektor gebildet wird,

dass die Durchbruchsspannung des parasitären pnp-Transistors die Begrenzungsspannung (UZPT) der Punch through-Diode nicht unterschreitet indem die als

Emitter wirkende zwischen der schwach n-dotierten Halbleiterschicht (1) und der zweiten Deckelektrode (5) angeordnete mindestens eine p-dotierte Halbleiterschicht (6) geringer als 0,1 Mikrometer gewählt wird.

2. Halbleiteranordnung nach Anspruch 1, **dadurch gekennzeichnet, dass** der Abstand (W) der p-dotierten Halbleiterschicht (6) von der hoch p-dotierten Halbleiterschicht (2) kleiner oder größer oder gleich dem Abstand der hoch n-dotierten Halbleiterschicht (3) von der hoch p-dotierten Halbleiterschicht (2) ist.

3. Halbleiteranordnung nach Anspruch 1 oder 2, **dadurch gekennzeichnet, dass** die hoch n-dotierte Halbleiterschicht (3) die seitlichen Ränder der Halbleiteranordnung vollständig umschließt.

4. Halbleiteranordnung nach Anspruch 3, **dadurch gekennzeichnet, dass** die Breite (BNR) der hoch n-dotierten Halbleiterschicht (3) im Bereich der seitlichen Ränder der Halbleiteranordnung verschieden ist von der Breite (BN) der hoch n-dotierten Halbleiterschicht (3) im inneren Bereich der Halbleiteranordnung.

5. Halbleiteranordnung nach Anspruch 3 oder 4, **dadurch gekennzeichnet, dass** die Breite (BNR) der hoch n-dotierten Halbleiterschicht (3) im Bereich der seitlichen Ränder der Halbleiteranordnung größer ist als der Bereich, in dem das Kristallgitter der Halbleiteranordnung gestört ist.

6. Halbleiteranordnung nach einem der vorhergehenden Ansprüche, **dadurch gekenntzeichnet,** dass die im inneren Bereich der Halbleiteranordnung vorgesehenen p-dotierten Halbleiterschichten (6) und die hoch n-dotierten Halbleiterschichten (3) in Form von Streifen, Kreisen oder Sechsecken ausgeführt sind.

7. Halbleiteranordnung nach einem der vorhergehenden Ansprüche, **dadurch gekennzeichnet, dass** die Breite (BN) der hoch n-dotierten Halbleiterschichten (3) größer, kleiner oder gleich der Breite (BP) der p-dotierten Halbleiterschichten (6) ist.

8. Halbleiteranordnung nach einem der vorhergehenden Ansprüche, **dadurch gekennzeichnet, dass** die Breite (BN) der hoch n-dotierten Halbleiterschichten (3) und die Breiten (BP) der p-dotierten Halbleiterschichten (6) unterschiedlich sind.

9. Halbleiteranordnung nach einem der vorhergehenden Ansprüche, **dadurch gekennzeichnet, dass** die Abstände der hoch n-dotierten Halbleiterschichten (3) voneinander und die Abstände der p-dotierten Halbleiterschichten (6) voneinander jeweils variieren.

10. Halbleiteranordnung nach einem der vorhergehenden Ansprüche, **dadurch gekennzeichnet, dass** die Breite (BN) der hoch n-dotierten Halbleiterschichten (3) im inneren Bereich der Halbleiteranordnung größer oder gleich der Eindringtiefe der hoch n-dotierten Halbleiterschichten (3) in die schwach n-dotierte Halbleiterschicht (1) ist.

11. Halbleiteranordnung nach einem der vorhergehenden Ansprüche, **dadurch gekenntzeichnet,** dass die Breite (BP) der p-dotierten Halbleiterschichten (6) im inneren Bereich der Halbleiteranordnung größer oder gleich der Eindringtiefe der p-dotierten Halbleiterschichten (6) in die schwach n-dotierte Halbleiterschicht (1) ist.

12. Halbleiteranordnung nach einem der vorhergehenden Ansprüche, **dadurch gekennzeichnet, dass** zwischen der schwach n-dotierten Halbleiterschicht (1) und der zweiten Deckelektrode (5) eine einzige, von zwei hoch n-dotierten Halbleiterschichten (3) umgebene p-dotierte Halbleiterschicht (6) vorgesehen ist (Figur 3).

13. Halbleiteranordnung nach einem der vorhergehenden Ansprüche, **dadurch gekennzeichnet, dass** ihr eine pn-Diode parallel geschaltet ist (Figur 4).

14. Halbleiteranordnung zur Spannungsbegrenzung, mit einer ersten Deckelektrode (4), einer mit der ersten Deckelektrode (4) verbundenen, stark n-dotierten Halbleiterschicht (2), einer mit der stark n-dotierten Halbleiterschicht (2) verbundenen, schwach p-dotierten Halbleiterschicht (1), und einer zweiten Deckelektrode (5), wobei zwischen der schwach p-dotierten Halbleiterschicht (1) und der zweiten Deckelektrode (5) nebeneinander im Wechsel mindestens eine n-dotierte Halbleiterschicht (6) und zwei hoch p-dotierte Halbleiterschichten (3) vorgesehen sind, **dadurch gekennzeichnet, dass** die Durchbruchspannung nahezu unabhängig von der Temperatur ist und die Halbleiteranordnung einer Kombination einer pn-Diode mit einer Punchthrough-Diode entspricht und dass die Begrenzungsspannung (UZPT) so gewählt wird, dass sie stets kleiner ist als die Durchbruchspannung (UZPN) der pn-Diode, wobei ein parasitare npn-Transistor durch die zwischen der schwach p-dotierten Halbleiterschicht (1) und der zweiten Deckefektrode (5) angeordnete mindestens eine n-dotierte Halbleiterschicht (6) als Emitter, der schwach p-dotierten Halbleiterschicht (1) als Basis und der mit der ersten Deckelektrode (4) verbundenen, stark n-dotierten Halbleiterschicht (2) als Kollektor gebildet wird, **dadurch gekennzeichnet,**
**dass** die Durchbruchsspannung eines parasitaren npn-Transistors die Begrenzungsspannung (UZPT) der Punchthrough-Diode nicht unterschreitet indem die als Emitter wirkende zwischen der schwach p-dotierten Halbleiterschicht (1) und der zweiten Deckelektrode (5) angeordnete mindestens eine n-dotierte Halbleiterschicht (6) geringer als 0,1 Mikrometer gewahlt wird.

15. Halbleiteranordnung nach Anspruch 14, **dadurch gekennzeichnet, dass** der Abstand (W) der n-dotierten Halbleiterschicht (6) von der hoch n-dotierten Halbleiterschicht (2) kleiner oder größer als oder gleich dem Abstand der hoch p-dotierten Halbleiterschicht (3) von der hoch n-dotierten Halbleiterschicht (2) ist.

16. Halbleiteranordnung nach Anspruch 14 oder 15, **dadurch gekennzeichnet, dass** die hoch p-dotierte Halbleiterschicht (3) die seitlichen Ränder der Halbleiteranordnung vollständig umschließt.

17. Halbleiteranordnung nach Anspruch 16, **dadurch gekennzeichnet, dass** die Breite (BNR) der hoch p-dotierten Halbleiterschicht (3) im Bereich der seitlichen Ränder der Halbleiteranordnung verschieden ist von der Breite (BN) der hoch p-dotierten Halbleiterschicht (3) im inneren Bereich der Halbleiteranordnung.

18. Halbleiteranordnung nach Anspruch 16 oder 17, **dadurch gekennzeichnet, dass** die Breite (BNR) der hoch p-dotierten Halbleiterschicht (3) im Bereich der seitlichen Ränder der Halbleiteranordnung größer ist als der Bereich, in dem das Kristallgitter der Halbleiteranordnung gestört ist.

19. Halbleiteranordnung nach einem der vorhergehenden Ansprüche 14-18, **dadurch gekennzeichnet, dass** die im inneren Bereich der Halbleiteranordnung vorgesehenen n-dotierten Halbleiterschichten (6) und die hoch p-dotierten Halbleiterschichten (3) in Form von Streifen, Kreisen oder Sechsecken ausgeführt sind.

20. Halbleiteranordnung nach einem der vorhergehenden Ansprüche 14-19, **dadurch gekennzeichnet, dass** die Breite (BN) der hoch p-dotierten Halbleiterschichten (3) größer, kleiner oder gleich der Breite (BP) der n-dotierten Halbleiterschichten (6) ist.

21. Halbleiteranordnung nach einem der vorhergehenden Ansprüche 14-20, **dadurch gekennzeichnet, dass** die Breite (BN) der hoch p-dotierten Halbleiterschichten (3) und die Breiten (BP) der n-dotierten Halbleiterschichten (6) unterschiedlich sind.

22. Halbleiteranordnung nach einem der vorhergehenden Ansprüche 14-21, **dadurch gekennzeichnet, dass** die Abstände der hoch p-dotierten Halbleiterschichten (3) voneinander und die Abstände der n-dotierten Halbleiterschichten (6) voneinander jeweils variieren.

23. Halbleiteranordnung nach einem der vorhergehenden Ansprüche 14-22, **dadurch gekennzeichnet, dass** die Breite (BN) der hoch p-dotierten Halbleiterschichten (3) im inneren Bereich der Halbleiteranordnung größer oder gleich der Eindringtiefe der hoch p-dotierten Halbleiterschichten (3) in die schwach p-dotierte Halbleiterschicht (1) ist.

24. Halbleiteranordnung nach einem der vorhergehenden Ansprüche 14-23, **dadurch gekenntzeichnet,** dass die Breite (BP) deren-dotierten Halbleiterschichten (6) im inneren Bereich der Halbleiteranordnung größer oder gleich der Eindringtiefe der n-dotierten Halbleiterschichten (6) in die schwach p-dotierte Halbleiterschicht (1) ist.

**25.** Halbleiteranordnung nach einem der vorhergehenden Ansprüche 14-24, **dadurch gekennzeichnet, dass** zwischen der schwach p-dotierten Halbleiterschicht (1) und der zweiten Deckelektrode (5) eine einzige, von zwei hoch p-dotierten Halbleiterschichten (3) umgebene n-dotierte Halbleiterschicht (6) vorgesehen ist (Figur 3).

**26.** Halbleiteranordnung nach einem der vorhergehenden Ansprüche 14-25 , **dadurch gekennzeichnet, dass** ihr eine pn-Diode parallel geschaltet ist (Figur 4).

**Claims**

**1.** Semiconductor arrangement for voltage limiting, comprising a first cover electrode (4), a heavily p-doped semiconductor layer (2) connected to the first cover electrode (4), a weakly n-doped semiconductor layer (1) connected to the heavily p-doped semiconductor layer (2), and a second cover electrode (5), wherein at least one p-doped semiconductor layer (6) and two highly n-doped semiconductor layers (3) are provided alternately alongside one another between the weakly n-doped semiconductor layer (1) and the second cover electrode (5), wherein the breakdown voltage is virtually independent of temperature, and the semiconductor arrangement corresponds to a combination of a pn diode with a punch-through diode, and wherein the limiting voltage (UZPT) of the punch-through diode is chosen such that it is always less than the breakdown voltage (UZPN) of the pn diode,
wherein a parasitic pnp transistor is formed by the at least one p-doped semiconductor layer (6), arranged between the weakly n-doped semiconductor layer (1) and the second cover electrode (5), as emitter, the weakly n-doped semiconductor layer (1) as base and the heavily p-doped semiconductor layer (2), connected to the first cover electrode (4), as collector,
wherein the breakdown voltage of the parasitic pnp transistor does not fall below the limiting voltage (UZPT) of the punch-through diode by virtue of the fact that the at least one p-doped semiconductor layer (6) arranged between the weakly n-doped semiconductor layer (1) and the second cover electrode (5) and acting as emitter is chosen to be smaller than 0.1 micrometer.

**2.** Semiconductor arrangement according to Claim 1, **characterized in that** the distance (W) between the p-doped semiconductor layer (6) and the highly p-doped semiconductor layer (2) is less than or greater than or equal to the distance between the highly n-doped semiconductor layer (3) and the highly p-doped semiconductor layer (2).

**3.** Semiconductor arrangement according to Claim 1 or 2, **characterized in that** the highly n-doped semiconductor layer (3) completely encloses the lateral edges of the semiconductor arrangement.

**4.** Semiconductor arrangement according to Claim 3, **characterized in that** the width (BNR) of the highly n-doped semiconductor layer (3) in the region of the lateral edges of the semiconductor arrangement is different from the width (BN) of the highly n-doped semiconductor layer (3) in the inner region of the semiconductor arrangement.

**5.** Semiconductor arrangement according to Claim 3 or 4, **characterized in that** the width (BNR) of the highly n-doped semiconductor layer (3) in the region of the lateral edges of the semiconductor arrangement is greater than in the region in which the crystal lattice of the semiconductor arrangement is disturbed.

**6.** Semiconductor arrangement according to any of the preceding claims, **characterized in that** the p-doped semiconductor layers (6) provided in the inner region of the semiconductor arrangement and the highly n-doped semiconductor layers (3) are embodied in the form of strips, circles or hexagons.

**7.** Semiconductor arrangement according to any of the preceding claims, **characterized in that** the width (BN) of the highly n-doped semiconductor layers (3) is greater than, less than or equal to the width (BP) of the p-doped semiconductor layers (6).

**8.** Semiconductor arrangement according to any of the preceding claims, **characterized in that** the width (BN) of the highly n-doped semiconductor layers (3) and the widths (BP) of the p-doped semiconductor layers (6) are different.

**9.** Semiconductor arrangement according to any of the preceding claims, **characterized in that** the distances between the highly n-doped semiconductor layers (3) and the distances between the p-doped semiconductor layers (6) vary in each case.

10. Semiconductor arrangement according to any of the preceding claims, **characterized in that** the width (BN) of the highly n-doped semiconductor layers (3) in the inner region of the semiconductor arrangement is greater than or equal to the penetration depth of the highly n-doped semiconductor layers (3) into the weakly n-doped semiconductor layer (1).

11. Semiconductor arrangement according to any of the preceding claims, **characterized in that** the width (BP) of the p-doped semiconductor layers (6) in the inner region of the semiconductor arrangement is greater than or equal to the penetration depth of the p-doped semiconductor layers (6) in to the weakly n-doped semiconductor layer (1).

12. Semiconductor arrangement according to any of the preceding claims, **characterized in that** a single p-doped semiconductor layer (6) surrounded by two highly n-doped semiconductor layers (3) is provided between the weakly n-doped semiconductor layer (1) and the second cover electrode (5) (Figure 3).

13. Semiconductor arrangement according to any of the preceding claims, **characterized in that** a pn diode is connected in parallel with said semiconductor arrangement (Figure 4).

14. Semiconductor arrangement for voltage limiting, comprising a first cover electrode (4), a heavily n-doped semiconductor layer (2) connected to the first cover electrode (4), a weakly p-doped semiconductor layer (1) connected to the heavily n-doped semiconductor layer (2), and a second cover electrode (5), wherein at least one n-doped semiconductor layer (6) and two highly p-doped semiconductor layers (3) are provided alternately alongside one another between the weakly p-doped semiconductor layer (1) and the second cover electrode (5), **characterized in that** the breakdown voltage is virtually independent of temperature, and the semiconductor arrangement corresponds to a combination of a pn diode with a punch-through diode, and **in that** the limiting voltage (UZPT) is chosen such that it is always less than the breakdown voltage (UZPN) of the pn diode,
   wherein a parasitic npn transistor is formed by the at least one n-doped semiconductor layer (6), arranged between the weakly p-doped semiconductor layer (1) and the second cover electrode (5), as emitter, the weakly p-doped semiconductor layer (1) as base and the heavily n-doped semiconductor layer (2), connected to the first cover electrode (4), as collector,
   **characterized in that** the breakdown voltage of a parasitic npn transistor does not fall below the limiting voltage (UZPT) of the punch-through diode by virtue of the fact that the at least one n-doped semiconductor layer (6) arranged between the weakly p-doped semiconductor layer (1) and the second cover electrode (5) and acting as emitter is chosen to be smaller than 0.1 micrometer.

15. Semiconductor arrangement according to Claim 14, **characterized in that** the distance (W) between the n-doped semiconductor layer (6) and the highly n-doped semiconductor layer (2) is less than or greater than or equal to the distance between the highly p-doped semiconductor layer (3) and the highly n-doped semiconductor layer (2).

16. Semiconductor arrangement according to Claim 14 or 15, **characterized in that** the highly p-doped semiconductor layer (3) completely encloses the lateral edges of the semiconductor arrangement.

17. Semiconductor arrangement according to Claim 16, **characterized in that** the width (BNR) of the highly p-doped semiconductor layer (3) in the region of the lateral edges of the semiconductor arrangement is different from the width (BN) of the highly p-doped semiconductor layer (3) in the inner region of the semiconductor arrangement.

18. Semiconductor arrangement according to Claim 16 or 17, **characterized in that** the width (BNR) of the highly p-doped semiconductor layer (3) in the region of the lateral edges of the semiconductor arrangement is greater than in the region in which the crystal lattice of the semiconductor arrangement is disturbed.

19. Semiconductor arrangement according to any of the preceding Claims 14-18, **characterized in that** the n-doped semiconductor layers (6) provided in the inner region of the semiconductor arrangement and the highly p-doped semiconductor layers (3) are embodied in the form of strips, circles or hexagons.

20. Semiconductor arrangement according to any of the preceding Claims 14-19, **characterized in that** the width (BN) of the highly p-doped semiconductor layers (3) is greater than, less than or equal to the width (BP) of the n-doped semiconductor layers (6).

21. Semiconductor arrangement according to any of the preceding Claims 14-20, **characterized in that** the width (BN) of the highly p-doped semiconductor layers (3) and the widths (BP) of the n-doped semiconductor layers (6) are different.

22. Semiconductor arrangement according to any of the preceding Claims 14-21, **characterized in that** the distances between the highly p-doped semiconductor layers (3) and the distances between the n-doped semiconductor layers (6) vary in each case.

23. Semiconductor arrangement according to any of the preceding Claims 14-22, **characterized in that** the width (BN) of the highly p-doped semiconductor layers (3) in the inner region of the semiconductor arrangement is greater than or equal to the penetration depth of the highly p-doped semiconductor layers (3) into the weakly p-doped semiconductor layer (1).

24. Semiconductor arrangement according to any of the preceding Claims 14-23, **characterized in that** the width (BP) of the n-doped semiconductor layers (6) in the inner region of the semiconductor arrangement is greater than or equal to the penetration depth of the n-doped semiconductor layers (6) in to the weakly p-doped semiconductor layer (1).

25. Semiconductor arrangement according to any of the preceding Claims 14-24, **characterized in that** a single n-doped semiconductor layer (6) surrounded by two highly p-doped semiconductor layers (3) is provided between the weakly p-doped semiconductor layer (1) and the second cover electrode (5) (Figure 3).

26. Semiconductor arrangement according to any of the preceding Claims 14-25, **characterized in that** a pn diode is connected in parallel with said semiconductor arrangement (Figure 4).

**Revendications**

1. Système à semi-conducteur destiné à limiter la tension, comportant une première électrode de recouvrement (4), une couche de semi-conducteur fortement dopée de type p (2), connectée à la première électrode de recouvrement (4), une couche de semi-conducteur faiblement dopée de type n (1), connectée à la couche de semi-conducteur fortement dopée de type p (2), et une deuxième électrode de recouvrement (5), dans lequel il est prévu entre la couche de semi-conducteur faiblement dopée de type n (1) et la deuxième électrode de recouvrement (5), côte à côte et de manière alternée, au moins une couche de semi-conducteur dopée de type p (6) et deux couches de semi-conducteur fortement dopées de type n (3), dans lequel la tension de claquage est pratiquement indépendante de la température et le système à semi-conducteur correspond à une combinaison d'une diode pn et d'une diode de claquage et dans lequel la tension de limitation (UZPT) de la diode de claquage est sélectionnée de manière à être invariablement inférieure à la tension de claquage (UZPN) de la diode pn,
dans lequel un transistor pnp parasite est formé par l'au moins une couche de semi-conducteur dopée de type p (6) disposée entre la couche de semi-conducteur faiblement dopée de type n (1) et la deuxième électrode de recouvrement (5), en tant qu'émetteur, la couche de semi-conducteur faiblement dopée de type n (1), en tant que base, et la couche de semi-conducteur fortement dopée de type p (2), connectée à la première électrode de recouvrement (4), en tant que collecteur, **caractérisé en ce que** la tension de claquage du transistor pnp parasite ne s'abaisse pas en dessous de la tension de limitation (UZPT) de la diode de claquage en raison du fait que l'au moins une couche de semi-conducteur de type p (6) disposée entre la couche de semi-conducteur faiblement dopée de type n (1) et la deuxième électrode de recouvrement (5) est sélectionnée de manière à être inférieure à 0,1 micromètre.

2. Système à semi-conducteur selon la revendication 1, **caractérisé en ce que** la distance (W) entre la couche de semi-conducteur dopée de type p (6) et la couche de semi-conducteur fortement dopée de type p (2) est inférieure ou supérieure ou égale à la distance entre la couche de semi-conducteur fortement dopée de type n (3) et la couche de semi-conducteur fortement dopée de type p (2).

3. Système à semi-conducteur selon la revendication 1 ou 2, **caractérisé en ce que** la couche de semi-conducteur fortement dopée de type n (3) entoure entièrement les bords latéraux du système à semi-conducteur.

4. Système à semi-conducteur selon la revendication 3, **caractérisé en ce que** la largeur (BNR) de la couche de semi-conducteur fortement dopée de type n (3) dans la région des bords latéraux du système à semi-conducteur est différente de la largeur (BN) de la couche de semi-conducteur fortement dopée de type n (3) dans la région interne du système à semi-conducteur.

**5.** Système à semi-conducteur selon la revendication 3 ou 4, **caractérisé en ce que** la largeur (BNR) de la couche de semi-conducteur fortement dopée de type n (3) dans la région des bords latéraux du système à semi-conducteur est supérieure à la région dans laquelle le réseau cristallin du système à semi-conducteur est perturbé.

**6.** Système à semi-conducteur selon l'une des revendications précédentes, **caractérisé en ce que** la couche de semi-conducteur dopée de type p (6) prévue dans la région interne du système à semi-conducteur et les couches de semi-conducteur fortement dopées de type n (3) sont réalisées sous la forme de bandes, de cercles ou d'hexagones.

**7.** Système à semi-conducteur selon l'une des revendications précédentes, **caractérisé en ce que** la largeur (BN) des couches de semi-conducteur fortement dopées de type n (3) est inférieure ou égale à la largeur (BP) des couches de semi-conducteur dopées de type p (6).

**8.** Système à semi-conducteur selon l'une des revendications précédentes, **caractérisé en ce que** la largeur (BN) des couches de semi-conducteur fortement dopées de type n (3) et les largeurs (BP) des couches de semi-conducteur dopées de type p (6) sont différentes.

**9.** Système à semi-conducteur selon l'une des revendications précédentes, **caractérisé en ce que** les distances entre les couches de semi-conducteur fortement dopées de type n (3) et les distances entre les couches de semi-conducteur dopées de type p (6) varient respectivement les unes par rapport aux autres.

**10.** Système à semi-conducteur selon l'une des revendications précédentes, **caractérisé en ce que** la largeur (BN) des couches de semi-conducteur fortement dopées de type n (3) dans la région interne du système à semi-conducteur est supérieure ou égale à la profondeur de pénétration des couches de semi-conducteur fortement dopées de type n (3) dans la couche de semi-conducteur faiblement dopée de type n (1).

**11.** Système à semi-conducteur selon l'une des revendications précédentes, **caractérisé en ce que** la largeur (BP) des couches de semi-conducteur dopées de type p (6) dans la région interne du système à semi-conducteur est supérieure ou égale à la profondeur de pénétration des couches de semi-conducteur dopées de type p (6) dans la couche de semi-conducteur faiblement dopée de type n (1).

**12.** Système à semi-conducteur selon l'une des revendications précédentes, **caractérisé en ce qu'**il est prévu entre la couche de semi-conducteur faiblement dopée de type n (1) et la deuxième électrode de recouvrement (5) une couche de semi-conducteur dopée de type p (6) unique entourée par deux couches de semi-conducteur fortement dopées de type n (3) (figure 3).

**13.** Système à semi-conducteur selon l'une des revendications précédentes, **caractérisé en ce qu'**une diode pn est connectée en parallèle à celle-ci (figure 4).

**14.** Système à semi-conducteur destiné à limiter la tension, comportant une première électrode de recouvrement (4), une couche de semi-conducteur fortement dopée de type n (2), connectée à la première électrode de recouvrement (4), une couche de semi-conducteur faiblement dopée de type p (1), connectée à la couche de semi-conducteur fortement dopée de type n (2), et une deuxième électrode de recouvrement (5), dans lequel il est prévu entre la couche de semi-conducteur faiblement dopée de type p (1) et la deuxième électrode de recouvrement (5), côte à côte et de manière alternée, au moins une couche de semi-conducteur dopée de type n (6) et deux couches de semi-conducteur fortement dopées de type p (3), **caractérisé en ce que** la tension de claquage est pratiquement indépendante de la température et **en ce que** le système à semi-conducteur correspond à une combinaison d'une diode pn et d'une diode de claquage et **en ce que** la tension de limitation (UZPT) est sélectionnée de manière à être invariablement inférieure à la tension de claquage (UZPN) de la diode pn, dans lequel un transistor npn parasite est formé par l'au moins une couche de semi-conducteur dopée de type n (6) disposée entre la couche de semi-conducteur fortement dopée de type p (1) et la deuxième électrode (5), en tant qu'émetteur, la couche de semi-conducteur faiblement dopée de type p (1), en tant que base, et la couche de semi-conducteur fortement dopée de type n (2) connectée à la première électrode (4), en tant que collecteur, **caractérisé en ce que** la tension de claquage d'un transistor npn parasite ne s'abaisse pas en dessous de la tension de limitation (UZPT) de la diode de claquage en raison du fait que l'au moins une couche de semi-conducteur dopée de type n (6) fonctionnant en tant qu'émetteur disposée entre la couche de semi-conducteur faiblement dopée de type p (1) et la deuxième électrode de recouvrement (5) est sélectionnée de manière à être inférieure à 0,1 micromètre.

**15.** Système à semi-conducteur selon la revendication 14, **caractérisé en ce que** la distance (W) entre la couche de semi-conducteur dopée de type n (6) et la couche de semi-conducteur fortement dopée de type n (2) est inférieure ou égale à la distance entre la couche de semi-conducteur fortement dopée de type p (3) et la couche de semi-conducteur fortement dopée de type n (2).

**16.** Système à semi-conducteur selon la revendication 14 ou 15, **caractérisé en ce que** la couche de semi-conducteur fortement dopée de type p (3) entoure entièrement les bords latéraux du système à semi-conducteur.

**17.** Système à semi-conducteur selon la revendication 16, **caractérisé en ce que** la largeur (BNR) de la couche de semi-conducteur fortement dopée de type p (3) dans la région des bords latéraux du système à semi-conducteur est différente de la largeur (BN) de la couche de semi-conducteur fortement dopée de type p (3) dans la région interne du système à semi-conducteur.

**18.** Système à semi-conducteur selon la revendication 16 ou 17, **caractérisé en ce que** la largeur (BNR) de la couche de semi-conducteur fortement dopée de type p (3) dans la région des bords latéraux du système à semi-conducteur est supérieure à la région dans laquelle le réseau cristallin du système à semi-conducteur est perturbé.

**19.** Système à semi-conducteur selon l'une quelconque des revendications 14 à 18 précédentes, **caractérisé en ce que** les couches de semi-conducteur dopées de type n (6) prévues dans la région interne du système à semi-conducteur et les couches de semi-conducteur fortement dopées de type p (3) sont réalisées sous la forme de bandes, de cercles, ou d'hexagones.

**20.** Système à semi-conducteur selon l'une quelconque des revendications 14 à 19 précédentes, **caractérisé en ce que** la largeur (BN) des couches de semi-conducteur fortement dopées de type p (3) est supérieure, inférieure ou égale à la largeur (BP) des couches de semi-conducteur dopées de type n (6).

**21.** Système à semi-conducteur selon l'une des revendications 14 à 20 précédentes, **caractérisé en ce que** la largeur (BN) des couches de semi-conducteur fortement dopées de type p (3) et les largeurs (BP) des couches de semi-conducteur dopées de type n (6) sont différentes.

**22.** Système à semi-conducteur selon l'une des revendications 14 à 21 précédentes, **caractérisé en ce que** les distances entre les couches de semi-conducteur fortement dopées de type p (3) et les distances entre les couches de semi-conducteur dopées de type n (6) varient respectivement les unes par rapport aux autres.

**23.** Système à semi-conducteur selon l'une des revendications 14 à 22 précédentes, **caractérisé en ce que** la largeur (BN) des couches de semi-conducteur fortement dopées de type p (3) dans la région interne du système à semi-conducteur est supérieure ou égale à la profondeur de pénétration des couches de semi-conducteur fortement dopées, de type p (3) dans la couche de semi-conducteur faiblement dopée de type p (1).

**24.** Système à semi-conducteur selon l'une des revendications 14 à 23 précédentes, **caractérisé en ce que** la largeur (BP) des couches de semi-conducteur dopées de type n (6) dans la région interne du système à semi-conducteur est supérieure ou égale à la profondeur de pénétration des couches de semi-conducteur dopées de type n (6) dans la couche de semi-conducteur faiblement dopée de type p (1).

**25.** Système à semi-conducteur selon l'une des revendications 14 à 24 précédentes, **caractérisé en ce qu'**il est prévu entre la couche de semi-conducteur faiblement dopée de type p (1) et la deuxième électrode de recouvrement (5) une couche de semi-conducteur dopée de type n (6) unique entourée par deux couches de semi-conducteur fortement dopées de type p (3) (figure 3).

**26.** Système à semi-conducteur selon l'une des revendications 14 à 25 précédentes, **caractérisé en ce qu'**elle est connectée en parallèle à une diode pn (figure 4).

# Fig. 1
( Stand der Technik )

A

4

2

1

3

B                    5

log C [cm⁻³]

Schnitt AB                    x

# Fig. 2

BNR      BP      BN      K              6      5

                                              3

W                                             1

                                              2

                                              4

A

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3631136 A1
- US 5142347 A
- EP 0485059 A
- DE 2506102 A1
- EP 1191594 A